Europäisches Patentamt

European Patent Office

Office européen des brevets

(11) Veröffentlichungsnummer: **0 435 051 A2**

# (12) EUROPÄISCHE PATENTANMELDUNG

(21) Anmeldenummer: 90123662.0

(22) Anmeldetag: 08.12.90

(51) Int. Cl.5: **H01L 39/14, H01L 39/24**

(30) Priorität: 23.12.89 DE 3942823

(43) Veröffentlichungstag der Anmeldung:
03.07.91 Patentblatt 91/27

(84) Benannte Vertragsstaaten:
AT BE CH DE DK ES FR GB GR IT LI LU NL SE

(71) Anmelder: **Battelle-Institut e.V.**
**Am Römerhof 35 Postfach 900 160**
**W-6000 Frankfurt/Main 90(DE)**

(72) Erfinder: **Heide, Helmut, Dr.**
**Am Hohenstein 14**
**W-6233 Kelkheim(DE)**
Erfinder: **Grünthaler, Karl-Heinz, Dr.**
**Mozartstrasse 6a**
**W-6390 Usingen(DE)**
Erfinder: **Nielsen, Inken, Dr.**
**Querstrasse 3**
**W-6453 Seligenstadt(DE)**

(54) **Verfahren zur Herstellung von Hochtemperatur-Supraleiterdrähten mit hoher Stromtragfähigkeit sowie deren Verwendung zur Herstellung von supraleitenden Bauteilen.**

(57) Verfahren zur Herstellung eines duktilen Supraleiters mit hoher Stromtragfähigkeit in Form eines durch heißisostatisches Pressen und mechanische Umformtechnik erzeugten Drahtes, bei dem die supraleitende Phase, z.B. $Y_1BaA_2Cu_3O_{7-x}$ in einer duktilisierenden und den Sauerstoffpartialdruck stabilisierenden Silber/Silberoxid-Matrix eingelagert wird sowie von einem duktilen Metallmantel umhüllt ist, dadurch gekennzeichnet, daß die zum Umformen notwendige Temperaturbehandlung ebenfalls unter hohen Gasdrücken (HIP) vollzogen wird, wodurch die Supraleiterseele des Drahtmaterials dicht und fehlerfrei ist und die Mikrokristallite in der Richtung ihrer größten Stromtragfähigkeit in der Drahtachse ausgerichtet werden.

EP 0 435 051 A2

## VERFAHREN ZUR HERSTELLUNG VON HOCHTEMPERATUR-SUPRALEITERDRÄHTEN MIT HOHER STROM-TRAGFÄHIGKEIT SOWIE DEREN VERWENDUNG ZUR HERSTELLUNG VON SUPRALEITENDEN BAUTEILEN.

Die Erfindung betrifft ein Verfahren zur Herstellung von keramischen Hochtemperatur-Supraleitern in Drahtform, die sich durch hohe Stromtragfähigkeit auszeichnen sowie deren Verwendung.

Die Herstellung von Supraleitern in Drahtform mit Hilfe der sogenannten Powder-in-Tube-Methode und heißisostatischen Pressens mit nachfolgender Umformung zu Drähten wird in der DE 37 24 229-C2 beschrieben. Hiernach werden supraleitende Keramikpulver, z.B. das bekannte $Y_1Ba_2Cu_3O_{7-x}$ ("123"), mit Silber und/oder Silberoxid $Ag_2O$ gemischt und in z.B. Kupferrohrmaterial eingebracht. Dieses Arrangement wird mittels heißisostatischen Pressens hoch verdichtet, so daß ein durch mechanisches Umformen zu Draht verarbeitbarer "Precursor" entsteht. Bei geeigneter Prozessführung entsteht bei dieser Verfahrenskombination ein supraleitendes Drahtmaterial, welches in seinen Eigenschaften inzwischen auch in der Literatur beschrieben wurde (Appl. Phys. Lett. 54 (8), 766-768 (1989). Diese nach dem Stand der Technik hergestellten Drahtmaterialien zeigen eine gewisse Duktilität und behalten bei Biegebeanspruchung ihre für das betreffende "123"-Supraleiter-System typische Sprungtemperatur von ca. 87 K. Geringfügige Störungen im Supraleiter-Gefüge, die beim Biegen zwangsläufig auftreten, machen sich in der Sprungtemperatur zunächst kaum bemerkbar, da nach dem sogenannten Proximity-Effekt in einem polykristallinen Gefüge die Supraleitung gewisse Störungen überspringt. Leider machen sich derartige Störungen auf die kritische Stromtragfähigkeit eines Supraleiters erheblich stärker bemerkbar (App. Phys. Lett. 54 (8), 766-768 (1989).

Es muß auch festgestellt werden, daß eine dauernde Umformung des Gefüges der Supraleiter, z.B. durch mechanisches Rundhämmern des Drahtes, ähnliche Effekte hervorruft.

Diese Effekte schränken nun die technische Einsetzbarkeit der Supraleiter erheblich ein, denn sowohl das Biegen wie auch das Verformen zu dünneren Drahtquerschnitten sind elementar wichtige, unvermeidbare Vorgänge bei der Drahtherstellung, ebenso wie die Stromtragfähigkeit eines Supraleiterdrahtes neben der Sprungtemperatur sehr wichtig ist.

Es ist nun bekannt, daß metallische Formkörper wie Rohre und Drähte aus duktilen Metallen beim Kaltverformen immer härter werden und sich schließlich kaum noch verformen lassen. Dieser, durch hohe Versetzungsdichte in dem Metallgitter hervorgerufene Effekt, läßt sich durch Zwischenglühen wieder aufheben. Auch beim Ziehen der Supraleiterdrähte muß zwischengeglüht werden. Dieser Vorgang kann nun sehr negative Folgen auf den Supraleiter haben: Auf der einen Seite benötigt man eine bestimmte Temperatur, um das Metall weichzuglühen (bei Kupfer ca. 600 ° C). Auf der anderen Seite besitzen die höchst instabilen Supraleiter und die Additive, wie z.B. das $Ag_2O$, bei diesen Temperaturen schon erhebliche Sauerstoffpartialdrücke, die durch thermische Zersetzung zu einer Auflockerung der Gefüge führen (negative Auswirkungen auf die Stromtragfähigkeit).

Weiterhin hat sich gezeigt, daß in polykristallinen Supraleitern die Stromtragfähigkeit stark verbessert wird, wenn die Kristallite des Supraleiters eine bestimmte Ausrichtung im Gefüge besitzen. Beim "123" z.B. ist dies dann der Fall, wenn die Kristallite mit ihrer a/b-Ebene in Richtung der Drahtachse ausgerichtet sind. Eine solche Gefügeregelung läßt sich bei einem, dem Stande der Technik entsprechenden Verfahren nicht optimal realisieren.

Die DE-OS 37 42 032 beschreibt ein Verfahren zur Herstellung von Supraleitern hoher Filamentzahl in einem Bolzenrohr, das durch heißisostatisches Pressen kompaktiert wird. Nach der Verdichtung werden die derart hergestellten Bolzen auf herkömmliche Art und Weise stranggepreßt.

Die DE-37 27 381-C2 beschreibt ein Verfahren zur Herstellung eines weitgehend phasenreinen, oxidischen Hochtemperatur-Supraleiters, wobei die vorstehend angegebene supraleitende Phase ("123") als Pulverpreßling in einer duktilisierenden und den Sauerstoffpartialdruck stabilisierenden Matrix eingelagert und von einem duktilen Metallmantel umhüllt wird. Die zum Umformen notwendige Temperaturbehandlung erfolgt unter hohen Gasdrücken (HIP). Auf die vorstehend erläuterte Problematik bei der Herstellung eines Hochtemperatur-Supraleiterdrahtes wird dort aber nicht eingegangen.

Demgegenüber liegt der Erfindung die Aufgabe zugrunde, ein Verfahren vorzuschlagen, mit dem duktile Hochtemperatur-Supraleiterdrähte hergestellt werden können, die sich insbesondere durch eine hohe Stromtragfähigkeit auszeichnen und die auch den bei der Herstellung elektrischer Bauteile, beispielsweise von Spulen, mit Hilfe dieser Drähte üblichen Bearbeitungsschritten, beispielsweise Biegen, unterworfen werden können, ohne daß dabei ihre Eigenschaften fühlbar verschlechtert werden.

Die Lösung dieser Aufgabe gelingt durch die Merkmale von Patentanspruch 1.

Beide Nachteile von keramischen Supraleiterdrähten im Metallrohr, welche nach dem Stand der Technik gefertigt werden, nämlich
- die Anfälligkeit gegen Biegen sowie

- die unvollkommene Gefügeregelung

können erfindungsgemäß durch verblüffend einfache Maßnahmen bei der Herstellung eliminiert werden:

Im Verlauf der mechanischen Umformung der Precursoren mittels Ziehen, Hämmern, Walzen oder dgl. erfolgt das Zwischenglühen zur Duktilisierung der Metallummantelung sowie der metallischen Bindematrix des keramischen Supraleiters erfindungsgemäß unter hohem Gasdruck bis ca. 150 MPa und Temperaturen, bei denen das Metall, vorzugsweise Kupfer, weichgeglüht wird, also bei ca.600° C. D.h. erfindungsgemäß werden alle Zwischenprodukte bei der Drahtherstellung unter HIP-Bedingungen behandelt. Darüber hinaus werden kompakte fertige Bauteile aus solchen Supraleiterdrähten, wie z.B. Spulen, welche bei der Formgebung naturgemäß einer starken Biegebelastung ausgesetzt werden, nach der Fertigstellung ebenfalls gehipt.

Hierdurch werden folgende Vorteile erzielt, die für die technische Einsetzbarkeit derartiger Supraleiterdrähte von ausschlaggebender Bedeutung sind:

- Durch den hohen Druck beim Zwischenglühen wird das Supraleitergefüge, welches durch die Umformung stark gestört wird, in einen poren- und rißfreien Zustand überführt.
- Außerdem liegt der von außen auf das System einwirkende Gasdruck der HIP-Anlage um Größenordnungen über den Zersetzungsdrücken der Supraleiterphase sowie der Me/Me-Oxid-Matrix, welche in dem Supraleitersystem als Sauerstoffdonator fungiert. D.h. alle Phasen liegen bei dieser HIP-Zwischenbehandlung im festen Zustand vor. Zersetzungsreaktionen können also selbst bei hohen Zwischenglühtemperaturen nicht stattfinden.
- Der entscheidende Vorteil dieses erfindungsgemäßen Verfahrensschritts ist die Gefügeregelung der Supraleiterphase durch die zwischengeschalteten HIP-Behandlungen. Die Druckübertragung erfolgt nämlich bei den drahtartig geformten Zwischenprodukten nicht immer rein isostatisch, sondern radial auf den Metallmantel. Die innere Supraleiterseele des Drahtes gerät dadurch in einen gerichteten Spannungszustand, der in Richtung der Drahtachse verläuft. Es zeige sich nun, daß die Supraleiterkristallite bei der Rekristallisation des Gefüges auf diesen Spannungszustand dadurch reagieren, daß sie mit ihrer supraleitenden Vorzugsrichtung sich in dieser Richtung einregeln. Diese Erscheinung wurde bisher konkret beim System YBaCuO beobachtet, doch liegt hier offenbar ein allgemeines Prinzip vor: Kristallarten mit stark anisotropen Eigenschaften im Kristallgitter, wie Kompressibilität, E-Modul und - wie im Bauprinzip der Supraleiter existent - mit stark unterschiedlichen Bindungsarten (heterodesmische Strukturen) versuchen bei der Rekristallisation, z.B. unter Druck, den Spannungszustand durch gerichtetes Wachstum zu minimieren.


Biespiel

Nach einer vorteilhaften Ausführungsart der erfindungsgemäßen Herstellung eines Drahtes bzw. eines gewickelten Bauteils aus einem supraleitenden Kern und einem Kupfermantel wird entsprechend folgender Verfahrensschritte vorgegangen

| | |
|---|---|
| Pulvermischung herstellen:<br>$Y_1Ba_2Cu_3O_{7-x}$ + Ag + $Ag_2O$ | gemäß DE 37 24 229 C2 |

↓

| | |
|---|---|
| Preßling herstellen mittels<br>kaltisostatischen Pressens,<br>ca.300 MPa, D ca. 10 - 20 mm.<br>L ca. 100 mm | D = Dicke des Preßlings<br>L = Länge des Preßlings |

↓

| | |
|---|---|
| Ummantelung des Preßlings<br>mit Barrierrematerial aus<br>z.B. ringförmig verpreßter<br>Pulvermischung aus Cu+<br>$Cu_2O$+CuO, Di ca. 10-20 mm<br>Da ca. 15 - 30 mm | Di = innerer Durchmesser<br>der Ummantelung<br>Da = äußerer Durchmesser<br>der Ummantelung<br>gemäß Fig. 1 |

↓

Einfüllen d. Verbundes in Container,Container schließen

↓

heißisostatisches Pressen bei
650°C,150 MPa,1 h Haltezeit

↓

| | |
|---|---|
| Abdrehen des Containers auf<br>gleichmäßige Dicke,Vorberei-<br>tung auf Umlaufprozeß | Fig. 2a |

↓

| | |
|---|---|
| Reduzieren des Querschnitts<br>durch Hämmern, Walzen,<br>und/oder Ziehen | Fig. 2b |

↓

| | |
|---|---|
| Zwischenglühen unter HIP-<br>Bedingungen zum Weich-<br>glühen des Drahtmaterials<br>und zur Gefügeeinregelung | Fig. 2c |

↓

↓

```
┌─────────────────────────────────────────┐
│ Bauteilherstellung, z.B.                 │
│ gewickelte Spule                         │
│                                          │
└─────────────────────────────────────────┘
                      │
                      ▼
┌─────────────────────────────────────────┐
│ Abschließendes HIP'pen zur               │
│ endgültigen Einstellung des              │
│ Gefügezustandes                          │
└─────────────────────────────────────────┘
```

**Ansprüche**

1. Verfahren zur Herstellung eines duktilen Hochtemperatur-Supraleiterdrahtes mit hoher Stromtragfähigkeit durch heißisostatisches Pressen und mechanische Umformtechnik, wobei die supraleitende Phase, z.B. $Y_1Ba_2Cu_3O_{7-x}$ (das sogenannte "123") in einer duktilisierenden und den Sauerstoffpartialdruck stabilisierenden Silber/Silberoxid-Matrix eingelagert sowie von einem duktilen Metallmantel umhüllt wird, **dadurch gekennzeichnet,**
daß die zum Umformen notwendige Temperaturbehandlung ebenfalls unter hohen Gasdrücken (HIP) vollzogen wird, wodurch die Supraleiterseele des Drahtmaterials dicht und fehlerfrei ist und die Mikrokristallite in der Richtung ihrer größten Stromtragfähigkeit in der Drahtachse ausgerichtet sind.

2. Verwendung des duktilen Supraleiterdrahtes nach Anspruch 1 zur Herstellung von supraleitenden Bauteilen, wie einer Spule, aus Supraleiterdrähten, wobei nach dem Wickeln des Bauteiles mit Supraleiterdrähten ein letzter HIP-Zyklus zur endgültigen Konsolidierung des Gefüges und der Gefügeregelung eingesetzt wird.

Cu-Container ⸻

Cu+Cu$_2$O+CuO ⸻

Y Ba CuO+Ag+Ag$_2$ O ⸻

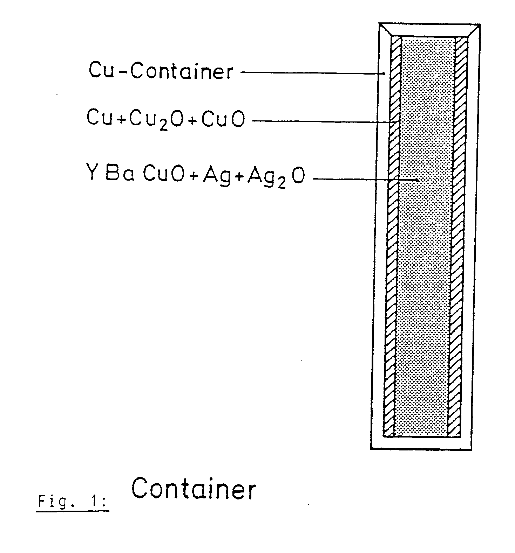

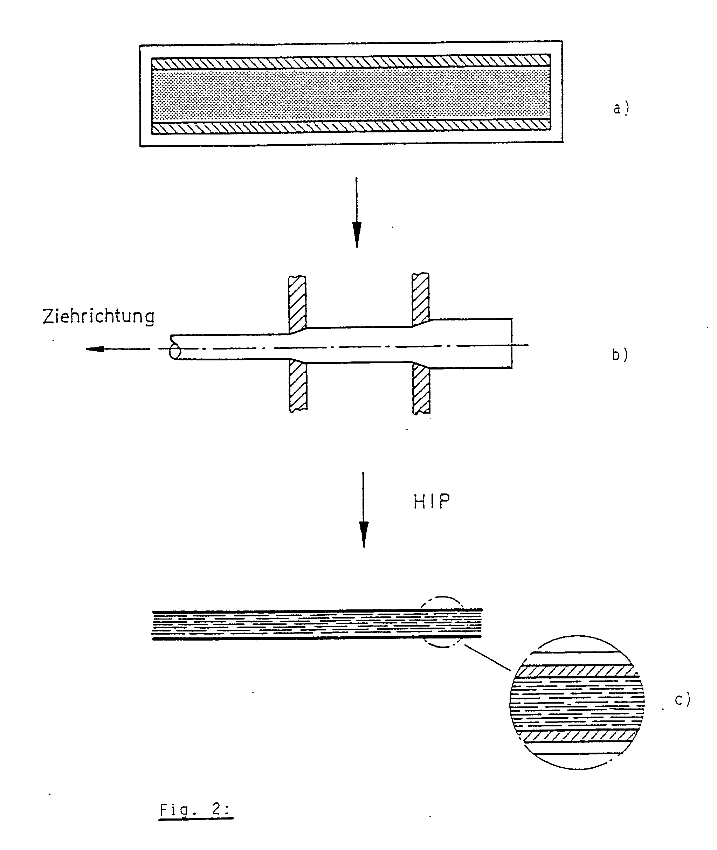

Fig. 1:  Container

a)

Ziehrichtung

b)

HIP

c)

Fig. 2: